# FASCICULE DE BREVET EUROPEEN

(11) **EP 4 362 627 B1**
(45) Date de publication et mention de la délivrance du brevet: **30.04.2025**
(21) Numéro de dépôt: 23204807.4
(22) Date de dépôt: 20.10.2023
(51) Int. Cl.: H10B 63/10, H10N 70/20

(54) **PROCÉDÉ DE FABRICATION D'UNE PUCE ÉLECTRONIQUE COMPRENANT UN CIRCUIT MÉMOIRE ET PUCE ÉLECTRONIQUE COMPRENANT UN CIRCUIT MÉMOIRE**
VERFAHREN ZUR HERSTELLUNG EINES ELEKTRONISCHEN CHIPS MIT EINER SPEICHERSCHALTUNG UND EINE SPEICHERSCHALTUNG
METHOD FOR MANUFACTURING AN ELECTRONIC CHIP COMPRISING A MEMORY CIRCUIT AND ELECTRONIC CHIP COMPRISING A MEMORY CIRCUIT

(30) Priorité: 27.10.2022 FR 2211193
(43) Date de publication de la demande: 01.05.2024
(73) Titulaire: STMicroelectronics Crolles 2 SAS, 38920 Crolles (FR)
(72) Inventeur: WEBER, Olivier, 38000 GRENOBLE (FR); BERTHELON, Remy, 38920 CROLLES (FR)
(74) Mandataire: Cabinet Beaumont

(56) Documents cités:
- US-A1- 2005 169 043
- US-A1- 2009 285 015
- US-A1- 2010 181 649

## Description

### Domaine technique

La présente description concerne de façon générale le domaine des puces électronique et vise plus particulièrement le domaine des puces électroniques comportant un circuit mémoire à base d'un matériau à changement de phase et leurs procédés de fabrication.

### Technique antérieure

Un matériau à changement de phase est un matériau ayant la capacité de changer d'état cristallin sous l'effet de la chaleur et plus particulièrement de commuter entre un état cristallin et un état amorphe, plus fortement résistif que l'étape cristallin. Ce phénomène est utilisé pour définir deux états mémoires, par exemple 0 et 1, différenciés par la résistance mesurée à travers le matériau à changement de phase.

Il existe un besoin d'amélioration des puces électroniques comportant un circuit mémoire comportant des points mémoires à base d'un matériau à changement de phase, et de leurs procédés de fabrication. Des exemples de l'art antérieur se trouve dans les documents US2005169043 A1 et US2009285015 A1.

### Résumé de l'invention

Un mode de réalisation pallie tout ou partie des inconvénients des puces électroniques comportant un circuit mémoire à base d'un matériau à changement de phase et de leurs procédés de fabrication.

Un mode de réalisation prévoit un procédé de fabrication d'une puce électronique comportant les étapes successives suivantes :
a) formation d'une première couche sur et en contact avec une deuxième couche semiconductrice dopée d'un premier type de conductivité, la deuxième couche étant sur et en contact avec une troisième couche semiconductrice dopée d'un deuxième type de conductivité opposé au premier type de conductivité ;
b) dopage de la première couche de sorte à former, sur la deuxième couche, une première sous-couche dopée du premier type de conductivité et une deuxième sous-couche dopée du deuxième type de conductivité ;
c) formation d'ilots dans la première couche organisés selon une matrice de lignes et de colonnes à la surface de la deuxième couche ; et
d) formation de points mémoires à base d'un matériau à changement de phase sur les ilots de la première couche, la deuxième couche, la troisième couche et la deuxième sous-couche de la première couche formant un transistor bipolaire.

Selon un mode de réalisation, le procédé comporte, après l'étape c), une étape e) d'épitaxie lors de laquelle une quatrième couche semiconductrice est formée entre les ilots de la première couche.

Selon un mode de réalisation, le procédé comporte, après l'étape e), une étape de dopage d'une zone de la quatrième couche du premier type de conductivité.

Selon un mode de réalisation, le procédé comporte, entre les étapes c) et e), une étape de formation d'espaceurs isolants électriquement autour des ilots.

Selon un mode de réalisation, des tranchées sont formées dans les deuxième et troisième couches, entre lesdits ilots, dans la direction des lignes.

Selon un mode de réalisation, un point mémoire est formé en vis-à-vis de chaque ilot.

Selon un mode de réalisation, la première couche est en silicium.

Selon un mode de réalisation, la première couche est en silicium polycristallin et est formée par dépôt.

Selon un mode de réalisation, lesdits ilots et points mémoire sont formés dans une zone mémoire de la puce, la puce comprenant en outre une zone logique, et à l'étape c), sont en outre formés, dans la première couche, en même temps que les ilots, des grilles de transistors MOS d'un circuit logique.

Selon un mode de réalisation, la première couche est en silicium monocristallin et est formée par épitaxie.

Un autre mode de réalisation prévoit une puce électronique comportant des ilots dans une première couche organisés selon une matrice de lignes et de colonnes, les ilots étant disposés à la surface d'une deuxième couche semiconductrice dopée d'un premier type de conductivité, elle-même située sur et en contact avec une troisième couche semiconductrice dopée d'un deuxième type de conductivité opposé au premier type de conductivité, la première couche comportant une première sous-couche dopée du premier type de conductivité, sur la deuxième couche et une deuxième sous-couche dopée du deuxième type de conductivité, les ilots étant surmontés de points mémoires à base de matériau à changement de phase, la deuxième couche, la troisième couche et la deuxième sous-couche de la première couche constituant un transistor bipolaire.

Selon un mode de réalisation, chaque ilot est entouré latéralement par des espaceurs électriquement isolants.

Selon un mode de réalisation, la première couche est en silicium polycristallin.

Selon un mode de réalisation, la première couche est en silicium monocristallin.

Selon un mode de réalisation, la puce électronique est formée par ledit procédé.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1A et la figure 1B illustrent deux vues en coupe, partielles et schématiques, d'un exemple de puce électronique ;

la figure 2A et la figure 2B illustrent deux vues en coupe, partielles et schématiques, d'une puce électronique selon un mode de réalisation ;

la figure 3, la figure 4, la figure 5, la figure 6, la figure 7, la figure 8 et la figure 9 sont des vues en coupe illustrant des étapes d'un procédé de fabrication de la puce électronique illustrée en figures 2A et 2B selon un premier mode de mise en oeuvre ; et

la figure 10 et la figure 11 sont des vues en coupe illustrant des étapes d'un procédé de fabrication de la puce électronique illustrée en figures 2A et 2B selon un deuxième mode de mise en oeuvre.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, seules les étapes permettant la réalisation du circuit mémoire ont été détaillées ci-après, la formation des autres éléments de la puce, par exemple d'un circuit logique situé à côté du circuit mémoire, étant à la portée de la personne du métier.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

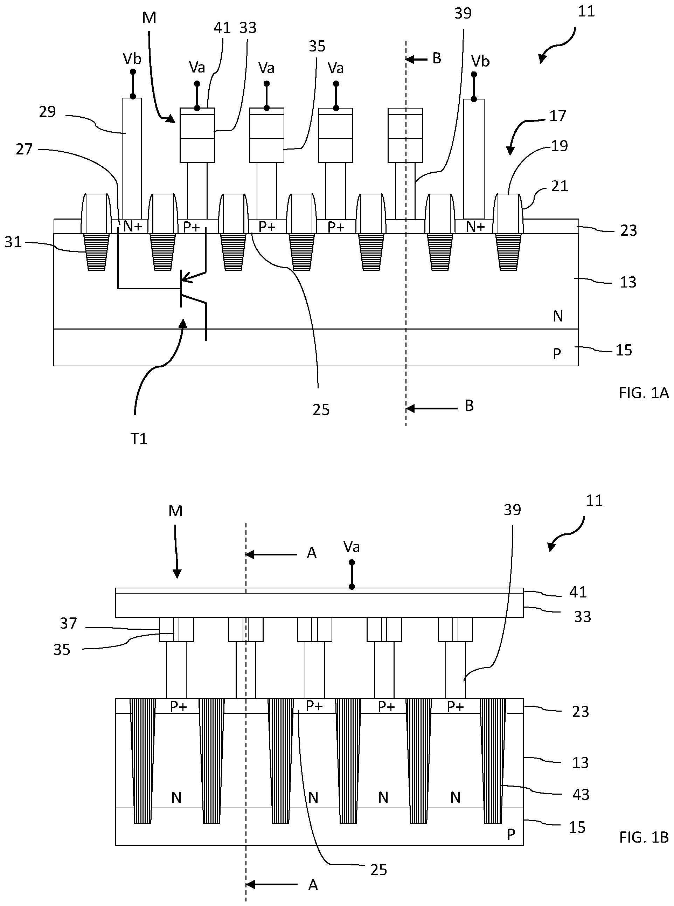

La figure 1A et la figure 1B illustrent deux vues en coupe, partielles et schématiques, d'un exemple de puce électronique 11, la figure 1A étant une vue selon le plan de coupe AA de la figure 1B et la figure 1B étant une vue selon le plan de coupe BB de la figure 1A.

Plus particulièrement, la figure 1A et la figure 1B illustrent une portion de la puce électronique 11 et plus précisément une portion d'un circuit mémoire de la puce électronique 11. A titre d'exemple, la puce électronique 11 comprend, dans une portion non représentée, un circuit logique adjacent au circuit mémoire.

La puce électronique 11 comprend des points mémoires M par exemple organisés, en vue de dessus, selon une matrice de lignes et de colonne. A titre d'exemple, les points mémoires M illustrés en figure 1A sont des points mémoires M d'une même ligne alors que les points mémoires illustrés en figure 1B sont des points mémoires d'une même colonne. On parle respectivement de lignes de mots (wordlines) et de lignes de bits (bitlines), chaque point mémoire M étant situé à l'intersection d'une ligne de bits et d'une ligne de mots. En figure 1A, seulement quatre lignes de bits sont représentées et en figure 1B seulement cinq lignes de mots sont représentées. Toutefois, en pratique, un circuit mémoire peut comprend un nombre de lignes de bits et de lignes de mots différent respectivement de quatre et cinq, par exemple supérieur à quatre et cinq.

A titre d'exemple, les points mémoires M sont à base d'un matériau à changement de phase 33, par exemple à base d'un matériau chalcogènure, par exemple un alliage de germanium, antimoine et tellure (GeSbTe) dit GST. Dans chaque point mémoire, le matériau à changement de phase est, par exemple, contrôlé par un élément résistif métallique chauffant 35 situé sous le matériau à changement de phase, par exemple en contact, par sa face supérieure, avec la face inférieure du matériau à changement de phase 33, et entouré latéralement d'un isolant thermique 37. Le matériau à changement de phase 33 est, par exemple surmonté par des métallisations 41, par exemple en un matériau conducteur. A titre d'exemple, dans chaque point mémoire M, les éléments métalliques 35 et 41 forment respectivement une électrode inférieure et une électrode supérieure de l'élément résistif à résistance variable formé par le matériau à changement de phase 33. A titre d'exemple, les points mémoires M d'une même ligne de bits sont surmontés d'une même métallisation 41. En d'autres termes, les électrode supérieures 41 des points mémoires M d'une même ligne de bits sont interconnectées. Les métallisations 41 sont, par exemple, couplées à des nœuds d'application de potentiels Va.

La puce 11 comprend une couche semiconductrice 13 dopée d'un premier type de conductivité, par exemple du type N, par exemple dopée d'atomes d'arsenic ou de phosphore. La couche 13 est, par exemple, en silicium. La couche 13 repose sur une couche semiconductrice 15 dopée d'un deuxième type de conductivité, opposé au premier type de conductivité, par exemple du type P, par exemple dopée d'atomes de bore . La couche 15 est, par exemple, en silicium.

A titre d'exemple, la puce 11 comprend des motifs de grille 17 disposés sur la face supérieure de la couche 13, par exemple s'étendant longitudinalement dans la direction des lignes de bits. Les motifs de grille 17 comportent, par exemple une partie centrale 19 entourée latéralement d'espaceurs 21. La partie centrale 19 de chaque motif de grille 17 est, par exemple en un matériau semiconducteur, par exemple en silicium, par exemple en silicium polycristallin. Les espaceurs 21 sont par exemple en un matériau isolant électriquement, par exemple en un nitrure de silicium.

Dans cet exemple, les motifs de grille 17 s'étendent, en vue de dessus, entre les lignes de bits de la matrice de points mémoire M. Autrement dit, dans cet exemple, en vue de dessus, deux lignes de bits consécutives quelconques de la matrice de points mémoire M sont séparées l'une de l'autre par un et un seul motif de grille 17 s'étendant sur toute la longueur desdites lignes de bit. Les motifs de grille 17 sont, par exemple séparés latéralement par une couche semiconductrice 23, par exemple formée par épitaxie à partir de la face supérieure de la couche 13. La couche 23 est, par exemple en silicium, par exemple en silicium monocristallin. A titre d'exemple, chaque point mémoire M est relié, par exemple connecté, à la couche 23 par l'intermédiaire d'un via 39. A titre d'exemple, le via 39 est en contact, par sa face supérieure, avec la face inférieure de l'élément résistif chauffant 35 du point mémoire M. Le via 39 est par exemple en contact, par sa face inférieure, avec la face supérieure de la couche 23.

La couche 23 comprend, par exemple des premières régions 25, par exemple dopées du deuxième type de conductivité, par exemple du type P, et s'étendant entre certains motifs de grille 17, à l'aplomb des points mémoires M de la matrice. Les régions 25 sont, par exemple plus fortement dopées que la couche 15. Chaque région 25 est, par exemple surmontée d'un point mémoire. A titre d'exemple, pour chaque point mémoire M, le via 39 correspondant relie électriquement l'élément chauffant 35 du point mémoire à la région 25 sous-jacente.

La couche 23 comprend, en outre, des deuxièmes régions 27, par exemple dopées du premier type de conductivité, par exemple du type N, et s'étendant entre d'autres motifs de grille 17. Les régions 27 sont, par exemple plus fortement dopées que la couche 13. Les régions 27, à la différence des régions 25, ne sont par exemple pas surmontées de points mémoires M mais de vias de reprise de contact 29. Les vias 29 permettent la reprise de contact des lignes de mots. A titre d'exemple, au sein d'une même ligne de mots, deux vias 29 sont espacés de, par exemple, quatre points mémoires M (appartenant respectivement à quatre lignes de bits consécutives). A titre d'exemple, les reprises de contact sont reliées à un nœud d'application d'un potentiel Vb appliqué à la ligne de mots concernée.

Les régions 27 et 25 sont, par exemple, délimitées latéralement par les motifs de grille 17 et par des tranchées d'isolation 31, par exemple des tranchées d'isolation très peu profondes (SSTI, de l'anglais "Super Shallow Trench Isolation"). Les tranchées d'isolation 31 empêchent, par exemple, des fuites de courant électrique entre deux lignes de bits successives. Les tranchées 31 sont alors, par exemple situées sous les motifs de grille 17. A titre d'exemple, les tranchées 31 sont linéaires et chaque motif de grille est situé sur et en contact avec une tranchée 31. A titre d'exemple, chaque tranchée 31 s'étend longitudinalement dans la direction des lignes de bits, sur toute la longueur des lignes de bits. A titre d'exemple, les tranchées 31 s'étendent, verticalement, dans la couche 13, à partir de la face supérieure de la couche 13 sur une partie seulement de l'épaisseur de la couche 13. Les tranchées d'isolation 31 sont par exemple remplies d'un matériau diélectrique, par exemple de l'oxyde de silicium. La profondeur des tranchées 31 est par exemple comprise entre 20 nm et 40 nm.

A titre d'exemple, la puce 11 comprend des tranchées d'isolation 43, par exemple des tranchées d'isolation peu profondes (STI, de l'anglais " Shallow Trench Isolation"). La profondeur des tranchées 43 est par exemple supérieure à la profondeur des tranchées 31. Les tranchées 43 s'étendent, par exemple, à partir de la face supérieure de la couche 13, dans la couche 13 et dans une partie de la couche 15. A titre d'exemple, les tranchées 43 permettent de séparer et donc d'isoler électriquement des bandes de la couche 13 à l'aplomb respectivement de chaque ligne de mots. A titre d'exemple, chaque tranchée 43 s'étend longitudinalement dans la direction des lignes de mots, sur toute la longueur des lignes de mots. Les tranchées d'isolation 43 sont par exemple remplies d'un matériau diélectrique, par exemple de l'oxyde de silicium. La profondeur des tranchées 43 est par exemple comprise entre 300 nm et 400 nm.

Dans l'exemple des figures 1A et 1B, pour chaque point mémoire M, la zone 25 située à l'aplomb du point mémoire, la couche 13 (et la zone 27) et la couche 15 définissent un transistor bipolaire T1, ici de type PNP, de sélection du point mémoire. Chaque point mémoire M est par exemple associé à un transistor bipolaire T1. Dans cet exemple, la région 25 constitue une région d'émetteur du transistor T1, la région 13 (et la zone 27) constitue une région de base du transistor T1 et la couche 15 constitue une région de collecteur du transistor T1. A titre d'exemple, le collecteur est commun à tous les transistors T1 de la matrice et est, par exemple, connecté à la masse. Dans cet exemple, la région de base 13 est commune à tous les transistors T1 d'une même ligne de mots du circuit mémoire.

Dans l'exemple de la figure 1A, les motifs de grille 17 ont notamment pour fonction de respecter des contraintes de densité surfacique de motifs de grille à l'échelle de la puce et de la tranche semiconductrice (wafer) dans et sur laquelle est formée la puce. Ces motifs n'ont pas de fonction électrique dans le circuit mémoire. Des motifs de grille de structure similaire ayant une fonction électrique peuvent en revanche être prévus dans un circuit logique situé à côté du circuit mémoire.

La présence des motifs de grille 17 au sein du circuit mémoire peut toutefois poser certains problèmes. Par exemple, malgré la présence des tranchées d'isolation 31 et des espaceurs 21, des courants de fuite parasites entre les motifs de grille 17 et les régions 25 (ou 27) peuvent exister, ce qui peut perturber la programmation ou la lecture des points mémoires M.

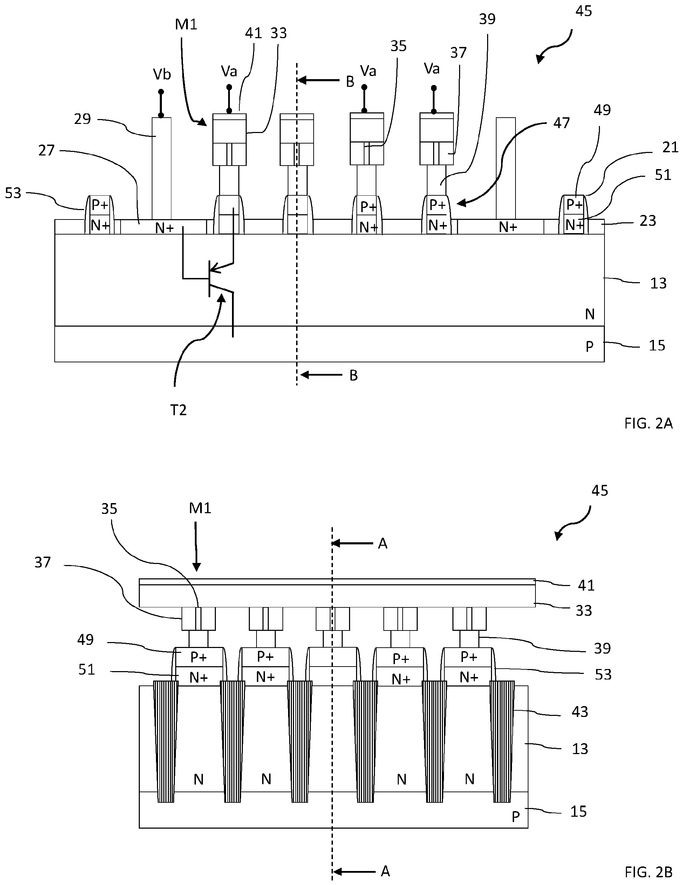

La figure 2A et la figure 2B illustrent deux vues en coupe, partielles et schématiques, d'une puce électronique 45 selon un mode de réalisation.

Plus particulièrement, la figure 2A illustre une vue selon le plan de coupe AA de la figure 2B et la figure 2B illustre une vue selon le plan de coupe BB de la figure 2A.

La puce électronique 45 illustrée en figures 2A et 2B est similaire à la puce 11 illustrée en figures 1A et 1B à la différence près que la jonction PN formée en figures 1A et 1B par les régions 25 et la couche 13 est formée, en figures 2A et 2B, dans des ilots 47 à la surface de la couche 13. Les ilots 47 se substituent aux motifs de grille 17 des figures 1A et 1B, non présents dans le circuit mémoire de la puce 45.

La puce électronique 45 comprend ainsi des ilots 47, par exemple parallélépipédiques. Les ilots 47 sont situés à la surface de la couche 13 et forment une grille ou matrice comportant des lignes et des colonnes similaire à la matrice des points mémoires M1. Chaque ilot 47 comprend un empilement d'une couche semiconductrice 49 dopée du deuxième type de conductivité, par exemple du type P et d'une couche semiconductrice 51 dopée du premier type de conductivité, par exemple du type N, la couche 51 étant sur et en contact avec la couche 13 et la couche 49 étant sur et en contact avec la couche 51. A titre d'exemple, la couche 49 est en silicium. A titre d'exemple, la couche 51 est en silicium. A titre d'exemple, les couches 51 et 49 sont respectivement plus fortement dopées que les couches 15 et 13.

A titre d'exemple, les ilots 47 sont entièrement entourés latéralement d'espaceurs 53. En d'autres termes, les ilots ont leurs quatre flancs recouverts d'espaceurs 53. A titre d'exemple, les espaceurs sont en un matériau isolant électriquement, par exemple en nitrure de silicium.

Les points mémoires M1 de la puce 45 sont formés sur et en contact avec les ilots 47, chaque point mémoire M1 étant associé à un unique ilot 47 et chaque ilot 47 étant associé à un unique point mémoire M1. Un point mémoire M1 a ainsi son via 39 situé sur et en contact avec la couche 49.

Similairement à ce qui a été décrit en relation avec les figures 1A et 1B, les ilots 47 sont séparés latéralement les uns des autres par la couche 23 épitaxiée comportant des régions 27 en vis-à-vis des vias 29 de reprise de contact des lignes de mots. Toutefois contrairement à ce qui a été décrit en relation avec les figures 1A et 1B, la couche 23 ne comprend pas de régions 25 et la couche 23 reste, par exemple non dopée, en dehors des régions 27.

A titre d'exemple, contrairement à ce qui a été décrit en relation avec les figures 1A et 1B, la puce 45 ne comprend pas de tranchées isolantes 31 supprimant ainsi une étape de gravure et réduisant les coûts de fabrication de la puce électronique en augmentant le rendement du procédé de fabrication. A titre d'exemple, la jonction PN des couches 49 et 51 est, pour chaque point mémoire M, isolée par les espaceurs 53.

Dans le mode de réalisation des figures 2A et 2B, pour chaque point mémoire M1, les couches 49 et 51 de l'ilot 47 sous-jacent, la couche 13 et la couche 15 constituent un transistor bipolaire T2 de sélection du point mémoire, ici de type PNP. Dans cet exemple, la couche 49 constitue une région d'émetteur du transistor T2, la couche 49 et la couche 13 constituent une région de base du transistor T2, et la couche 15 constitue un collecteur du transistor T2. A titre d'exemple, la région de base 13 est commune à tous les transistors T2 d'une même ligne de mots du circuit mémoire. A titre d'exemple, le collecteur est commun à tous les transistors T2 du circuit mémoire et est, par exemple, connecté à une masse.

Un avantage du mode de réalisation décrit en relation avec les figures 2A et 2B est que les courants de fuite sont réduits vis-à-vis d'une puce telle qu'illustrée en figures 1A et 1B.

Un autre avantage du mode de réalisation décrit en relation avec les figures 2A et 2B est qu'il permet de supprimer les tranchées d'isolation 31 ce qui permet de réduire les coûts de fabrication d'une puce.

Encore un autre avantage du mode de réalisation décrit en relation avec les figures 2A et 2B est qu'il peut permettre de réduire la distance entre deux lignes de bits et donc diminuer la taille d'une puce.

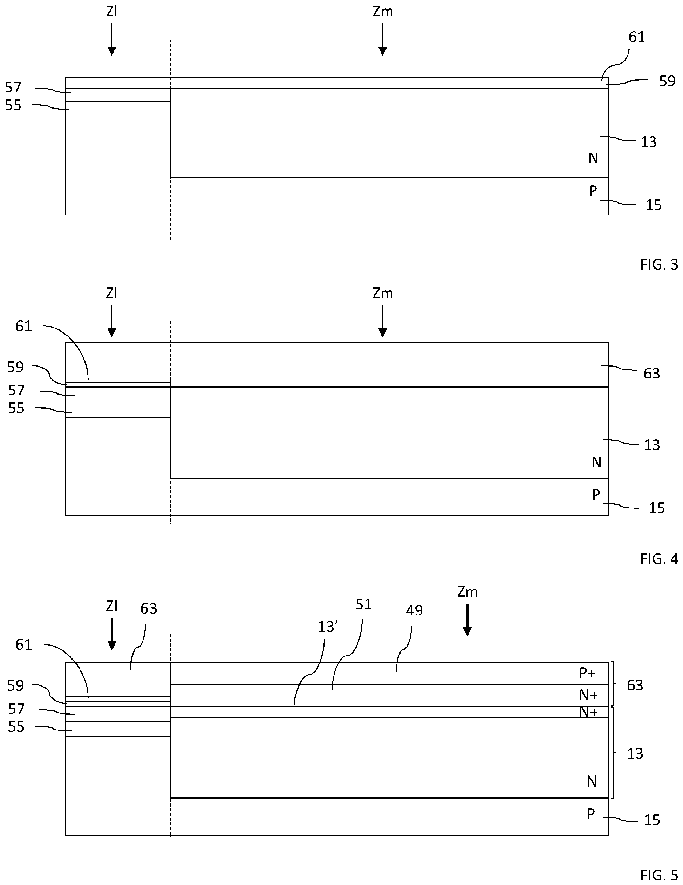

Des exemples de procédés de fabrication d'une telle puce vont maintenant être décrits en relation avec les figures 3 à 11.

Les figures 3 à 9 illustrent, par des vues en coupe, partielles et schématiques, des étapes successives d'un procédé de fabrication d'une puce telle qu'illustrée en figures 2A et 2B selon un premier mode de mise en oeuvre.

La figure 3 illustre une structure de départ comportant une zone mémoire Zm, dans laquelle souhaite former un circuit mémoire, et une zone logique Zl, dans laquelle on souhaite former un circuit logique comportant, par exemple, des transistors métal oxyde semiconducteur dits MOS (de l'anglais "Metal Oxide Semiconductor"). En figure 3, la zone mémoire Zm est représentée à droite et la zone logique Zl est représentée à gauche.

Dans la suite de la description, seule la formation du circuit mémoire sera détaillée.

La structure illustrée en figure 3 comprend la couche 15, par exemple du deuxième type de conductivité, par exemple du type P.

La structure comprend en outre, dans la zone logique Zl, une couche enterrée 55, par exemple isolante, par exemple en un oxyde, par exemple en oxyde de silicium, et une couche 57, par exemple semiconductrice, par exemple en silicium. A titre d'exemple, l'empilement des couches 15, 55 et 57 forme un substrat de type SOI (de l'anglais "Silicon on Insulator"). Dans sa zone mémoire Zl, la structure comporte, la couche 13 formée sur la couche 15. La zone mémoire de la structure illustrée en figure 3 ne comporte ni de couche 55 ni de couche 57. A titre d'exemple, le plan de la face supérieure de la couche 13 et le plan de la face supérieure de la couche 57 sont confondus. A titre d'exemple, les zones logique Zl et mémoire Zm sont recouvertes par une couche 59 en un matériau diélectrique et une couche conductrice 61, la couche 59 s'étendant de façon continue sur toute la surface de la structure, sur et en contact avec la face supérieure des couches 57 et 13, et la couche 61 s'étendant sur toute la surface de la structure, sur et en contact avec la face supérieure de la couche 59. La couche 61 est, par exemple une couche conductrice de grille, par exemple en un alliage à base de nitrure de titane (TiN). La couche 59 est, par exemple une couche d'isolant de grille, par exemple en un matériau ayant une constante diélectrique supérieure à la constante diélectrique du dioxyde de silicium, par exemple un oxyde de zirconium et/ou d'hafnium, par exemple en dioxyde de silicium, en siliciure d'hafnium ou en oxynitrure de silicium d'hafnium.

A titre d'exemple, les couches 13 et 15 sont en le même matériau et sont issues d'un même substrat ayant subi des implantations de dopants à différentes profondeurs.

La figure 4 illustre une structure obtenue à l'issue d'une étape de dépôt d'une couche semiconductrice 63 sur la face supérieure de la structure illustrée en figure 3.

Plus particulièrement, lors de cette étape, on vient d'abord retirer localement les couches 59 et 61 en vis à vis de la zone mémoire Zm, par exemple sur toute la surface de la zone mémoire Zm.

Le retrait des couches 59 et 61 est, par exemple réalisé par photolithogravure suivie de gravure.

Lors de cette étape, les couches 59 et 61 peuvent être conservées sur toute ou partie de la surface de la zone logique Zl.

La couche 63 est ensuite déposée, par exemple pleine plaque, sur l'ensemble de la face supérieure de la structure.

A l'issue de l'étape de dépôt de la couche 63, celle-ci recouvre la couche 13 en zone mémoire Zm et la couche 61 en zone logique Zl. Plus particulièrement, dans l'exemple représenté, la couche 63 est en contact avec la face supérieure de la couche 13 dans la zone mémoire Zm et avec la face supérieure de la couche 61 dans la zone logique Zl.

La couche 63 est, par exemple en silicium, par exemple en silicium monocristallin. A titre de variante, la couche 63 est en silicium polycristallin. A titre d'exemple, la couche 63 a une épaisseur, prise en zone mémoire Zm en vis-à-vis de la couche 13, comprise entre 20 nm et 80 nm, par exemple comprise entre 40 nm et 50 nm.

La couche 63 dans la zone logique est, par exemple, destinée à former des régions de reprise de contact de grille des transistors du circuit logique.

La figure 5 illustre une structure obtenue à l'issue d'une étape de dopages de la couche 63.

Plus particulièrement, lors de cette étape, on vient doper une partie inférieure de la couche 63 du premier type de conductivité, par exemple du type N, de sorte à former la couche ou sous-couche 51 et une partie supérieure de la couche 63 du deuxième type de conductivité, par exemple du type P, de sorte à former la couche ou sous-couche 49. Le dopage de la partie inférieure de la couche 63 et le dopage de la partie supérieure de la couche 63 sont, par exemple réalisés successivement.

A titre d'exemple, le dopage de la couche 63 formant la couche 51 est réalisé avant le dopage de la couche 61 formant la couche 49.

En variante, le dopage de la couche 63 formant la couche 49 est réalisé avant le dopage de la couche 61 formant la couche 51.

L'étape de dopage de la partie inférieure de la couche 63 pour former la couche 51 engendre, par exemple, le dopage d'une partie supérieure de la couche 13 sous-jacente à la couche 63 formant ainsi une couche ou sous-couche 13'.

A titre d'exemple, les couches 51, 49 et 13' sont plus fortement dopées que les couches 13 et 15.

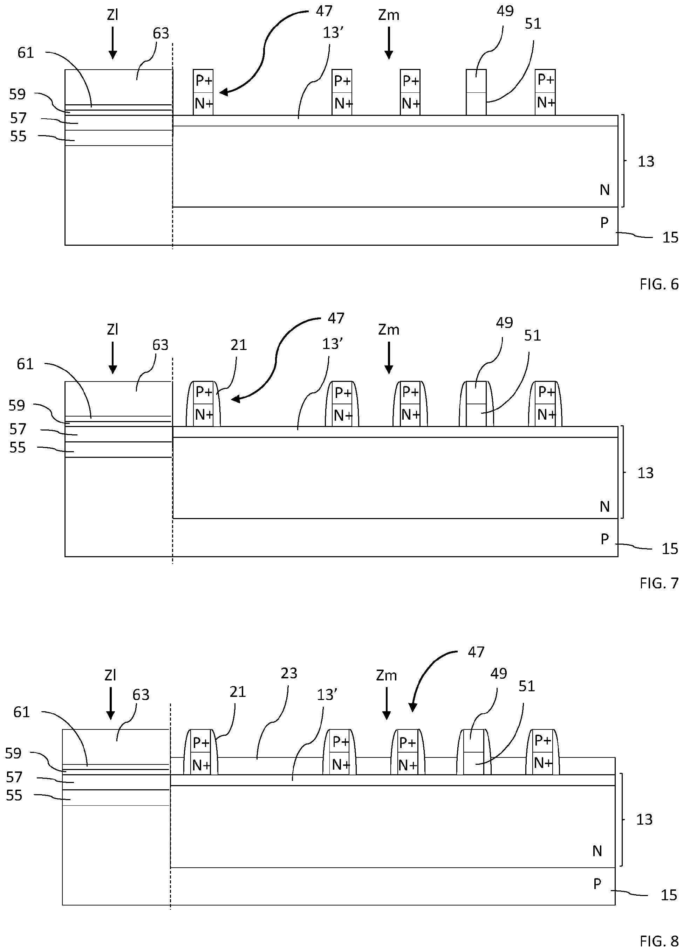

La figure 6 illustre une structure obtenue à l'issue d'une étape de formation des ilots 47, l'étape de formation des ilots 47 étant distincte de l'étape de dopage décrite en relation avec la figure 5.

Plus particulièrement, lors de cette étape, on vient graver dans les couches 49 et 51 des tranchées délimitant latéralement les ilots 47. A titre d'exemple, les ilots 47 sont agencés en matrice, selon des lignes et des colonnes. A titre d'exemple, en dehors des ilots 47, les couches 49 et 51 sont entièrement retirées, les tranchées gravées entre les ilots 47 débouchant sur la face supérieure de la couche 13, par exemple sur la face supérieure de la couche 13'. A titre d'exemple, les ilots sont formés avec un pas, par exemple constant, compris entre 20 nm et 300 nm, par exemple compris entre 100 nm et 200 nm, par exemple de l'ordre de 118 nm. A titre d'exemple, une colonne d'ilots 47 sur cinq est omise (i.e. gravée) afin de laisser la place aux vias 29 de reprise de contact des lignes de mots comme cela a été décrit en relation avec les figures 2A et 2B.

La gravure des couches 49 et 51 est, par exemple réalisée par un procédé de gravure sèche, par exemple un procédé classique de gravure de silicium polycristallin.

A tire d'exemple, lors de cette étape, en zone logique Zl, les grilles des transistors sont par exemple également gravées. Les étapes de gravure en zone logique Zl et en zone mémoire Zm sont par exemple réalisées au sein d'une même étape de gravure, le masque de gravure étant adapté pour les deux zones.

La figure 7 illustre une structure obtenue à l'issue d'une étape de formation des espaceurs 21 sur les flancs des ilots 47, par exemple sur toute la périphérie des ilots 47.

A titre d'exemple, lors de cette étape, les espaceurs 21 sont par exemple formés en zone mémoire Zm simultanément à des espaceurs autour de grilles de transistors dans la zone logique Zl.

La figure 8 illustre une structure obtenue à l'issue d'une étape de formation de la couche 23. L'étape de formation de la couche 23 est, par exemple distincte de l'étape de formation des ilots 47, les ilots 47 n'étant pas formés de la couche 23.

A titre d'exemple, la couche 23 est formée par épitaxie à partir de la face supérieure de la couche 13, ou le cas échéant de la couche 13'. L'étape de formation de la couche 23 est, pas exemple réalisée après l'étape de formation des espaceurs 21. La couche 23 est, par exemple en silicium, par exemple en silicium monocristallin.

A titre d'exemple, la couche 23 a une épaisseur comprise entre 5 nm et 50 nm, par exemple comprise entre 10 nm et 30 nm.

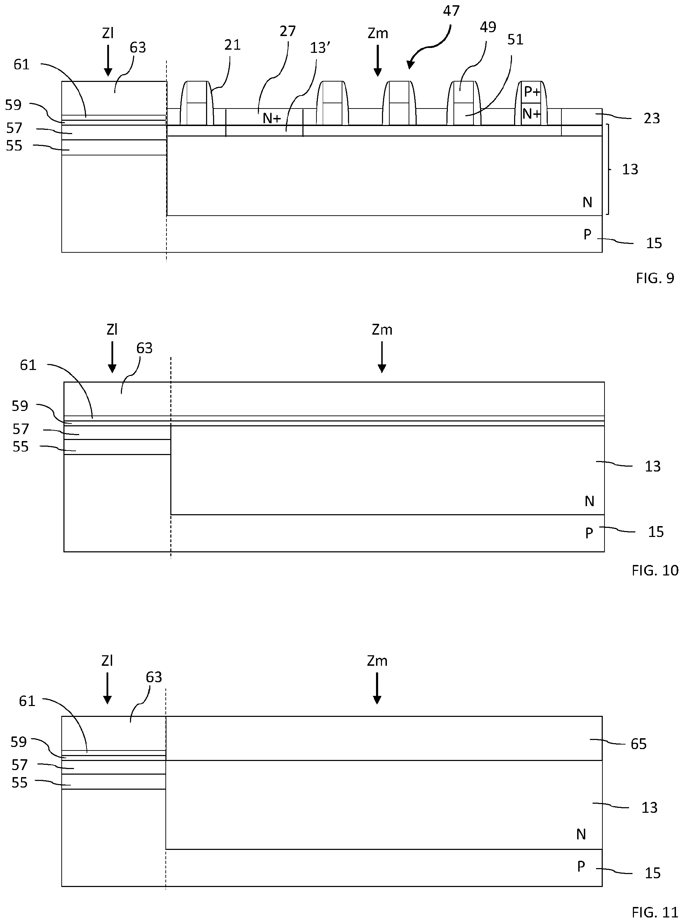

La figure 9 illustre une structure obtenue à l'issue d'une étape de dopage localisé de la couche 23.

Plus particulièrement, lors de cette étape, on vient former les régions 27 par dopage localisé de la couche 23. Les régions 27 sont par exemple formées par dopage du premier type de conductivité, par exemple du type N. La région 27 est par exemple plus fortement dopée que la couche 13. Les régions 27 sont par exemple formées à la place de la colonne d'ilots 47 omise, c'est-à-dire que chaque région 27 est comprise entre quatre colonnes d'ilots 47.

A l'issue de cette étape, les points mémoires M1 sont par exemple formés sur et en contact avec les ilots 47.

Les figures 10 et 11 illustrent des étapes d'un procédé de formation de la puce illustrée en relation avec les figures 2A et 2B selon un deuxième mode de mise en oeuvre.

Plus particulièrement, le procédé illustré en relation avec les figures 10 et 11 diffère du procédé illustré en relation avec les figures 3 à 9 en ce que les ilots 47 sont formés dans une couche épitaxiée.

La figure 10 illustre une structure obtenue à l'issue d'une étape de formation de la couche 63 sur la face supérieure de la structure illustrée en figure 3.

Lors de cette étape, à la différence de ce qui a été décrit précédemment en relation à la figure 3, la couche 63 est formée sur toute la surface supérieure de la structure, dans la zone mémoire Zm et la zone logique Zl, sans retrait préalable des couches 61 et 59 de la zone mémoire.

La couche 63 est ainsi en contact, par sa face inférieure, avec la face supérieure de la couche 61 sur toute la surface de la structure.

La figure 11 illustre une structure obtenue à l'issue d'une étape de formation d'une couche 65 épitaxiée.

La formation de la couche 65 est, par exemple précédée d'une étape de retrait, dans la zone mémoire Zm, de la couche 63 et des couches 61 et 59. Cette étape est, par exemple réalisée à travers un masque dur, par exemple à base de nitrure. Ce masque permet, par exemple, de conserver la couche 63 et les couches 61 et 59 dans la zone logique pour y former les grilles des transistors MOS. A titre d'exemple, à l'issue de l'étape de retrait, la face supérieure de la couche 13 est découverte. Cette étape est, par exemple réalisée par photolithographie puis gravure.

A la suite de l'étape de retrait des couches 63, 61 et 59, la couche 65 est formée par épitaxie à partir de la face supérieure de la couche 13. La couche 65 va donc croitre dans l'ouverture laissée par le retrait des couches 61, 59 et 63. A titre d'exemple, à l'issue de cette étape, la face supérieure de la structure formée est aplanie de sorte que le plan de la face supérieure de la couche 63 se confonde avec le plan de la face supérieure de la couche 65. A titre d'exemple, la couche 65 a une épaisseur comprise entre 20 nm et 80 nm, par exemple comprise entre 40 nm et 50 nm.

La suite du procédé est similaire à au procédé décrit en relation avec les figures 5 à 9. Plus particulièrement, à la suite des étapes décrites en relation avec les figures 10 et 11, on vient doper la couche 65, former les ilots 47, former la couche 23 et les points mémoire M1.

Dans ce mode de mise en oeuvre, le dopage de la couche 63 comprend un dopage du premier type de conductivité, sur une partie inférieure, afin de former la couche ou sous-couche 51 et du deuxième type de conductivité, sur une partie supérieure, afin de former la couche ou sous-couche 49. Les ilots 47 comportent ainsi deux couches 49 et 51 en silicium monocristallin.

Un avantage du mode de réalisation décrit en relation avec les figures 10 et 11 est qu'il permet d'augmenter la qualité des matériaux formant la jonction PN émetteur-base du transistor de sélection T2 de chaque point mémoire.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation ne se limitent pas aux exemples de valeurs numériques ni aux exemples de matériaux mentionnés dans la présente description.

Enfin, la mise en oeuvre pratique des modes de réalisation et variantes décrits est à la portée de la personne du métier à partir des indications fonctionnelles données ci-dessus.

## Revendications

1. Procédé de fabrication d'une puce électronique (45) comportant les étapes successives suivantes :
a) formation d'une première couche (63 ; 65) sur et en contact avec une deuxième couche semiconductrice (13) dopée d'un premier type de conductivité (N), la deuxième couche étant sur et en contact avec une troisième couche semiconductrice (15) dopée d'un deuxième type de conductivité (P) opposé au premier type de conductivité ;
b) dopage de la première couche (63 ; 65) de sorte à former, sur la deuxième couche, une première sous-couche (51) dopée du premier type de conductivité (N) et une deuxième sous-couche (49) dopée du deuxième type de conductivité (P) ;
c) formation d'ilots (47) dans la première couche (63 ; 65) organisés selon une matrice de lignes et de colonnes à la surface de la deuxième couche (13) ; et
d) formation de points mémoires (M1) à base d'un matériau à changement de phase (33) sur les ilots (47) de la première couche (63 ; 65), la deuxième couche (13), la troisième couche (15) et la deuxième sous-couche (49) de la première couche (63 ; 65) formant un transistor bipolaire (T2), après l'étape c), et caractérisé en une étape e) d'épitaxie lors de laquelle une quatrième couche semiconductrice (23) est formée entre les ilots (47) de la première couche (63 ; 65), et, entre les étapes c) et e), une étape de formation d'espaceurs (21) isolants électriquement autour des ilots (47).

2. Procédé selon la revendication 1, comportant, après l'étape e), une étape de dopage d'une zone (27) de la quatrième couche (23) du premier type de conductivité (N).

3. Procédé selon la revendication 1 ou 2, dans lequel des tranchées (43) sont formées dans les deuxième (13) et troisième (15) couches, entre lesdits ilots (47), dans la direction des lignes.

4. Procédé selon l'une quelconque des revendications 1 à 3, dans lequel, lors de l'étape d) de formation des points mémoires (M1), un desdits points mémoires (M1) est formé en vis-à-vis de chaque ilot (47).

5. Procédé selon l'une quelconque des revendications 1 à 4, dans lequel la première couche (63 ; 65) est en silicium.

6. Procédé selon la revendication 5, dans lequel la première couche (63) est en silicium polycristallin et est formée par dépôt.

7. Procédé selon la revendication 6, dans lequel lesdits ilots (47) et points mémoire (M1) sont formés dans une zone mémoire (Zm) de la puce, la puce comprenant en outre une zone logique (Zl), et dans lequel, à l'étape c), sont en outre formés, dans la première couche (63), en même temps que les ilots (47), des grilles de transistors MOS d'un circuit logique.

8. Procédé selon la revendication 6, dans lequel la première couche (65) est en silicium monocristallin et est formée par épitaxie.

9. Puce électronique (45) comportant des ilots (47) dans une première couche (63 ; 65) organisés selon une matrice de lignes et de colonnes, les ilots (47) étant disposés à la surface d'une deuxième couche semiconductrice (13) dopée d'un premier type de conductivité (N), elle-même située sur et en contact avec une troisième couche semiconductrice (15) dopée d'un deuxième type de conductivité (P) opposé au premier type de conductivité (N), la première couche (63 ; 65) comportant une première sous-couche (51) dopée du premier type de conductivité (N), sur la deuxième couche (13) et une deuxième sous-couche (49) dopée du deuxième type de conductivité (P), les ilots (47) étant surmontés de points mémoires (M1) à base de matériau à changement de phase (33), la deuxième couche (13), la troisième couche (15) et la deuxième sous-couche (49) de la première couche (63 ; 65) constituant un transistor bipolaire (T2), et **caractérisé en ce que** chaque ilot (47) est entouré latéralement par des espaceurs électriquement isolants (21), le dispositif comprenant en outre une quatrième couche semiconductrice (23) s'étendant entre les îlots (47).

10. Puce électronique selon la revendication 9, dans lequel la première couche (63) est en silicium polycristallin.

11. Puce électronique selon la revendication 9, dans lequel la première couche (65) est en silicium monocristallin.

12. Puce électronique (45) selon la revendication 9 formée par un procédé selon l'une quelconque des revendications 1 à 8.

## Patentansprüche

1. Verfahren zur Herstellung eines elektronischen Chips (45), das die folgenden aufeinanderfolgenden Schritte aufweist:
a) Ausbilden einer ersten Schicht (63; 65) auf und in Kontakt mit einer zweiten dotierten Halbleiterschicht (13) eines ersten Leitfähigkeitstyps (N), wobei die zweite Schicht auf und in Kontakt mit einer dritten dotierten Halbleiterschicht (15) eines zweiten Leitfähigkeitstyps (P) entgegengesetzt zum ersten Leitfähigkeitstyp ist;
b) Dotieren der ersten Schicht (63; 65), um auf der zweiten Schicht eine erste dotierte Teilschicht (51) des ersten Leitfähigkeitstyps (N) und eine zweite dotierte Teilschicht (49) des zweiten Leitfähigkeitstyps (P) zu bilden;
c) Ausbilden von Inseln (47) in der ersten Schicht (63; 65), die in einer Anordnung von Zeilen und Spalten an der Oberfläche der zweiten Schicht (13) angeordnet sind; und
d) Ausbilden von Speicherzellen (M1) auf der Grundlage eines Phasenänderungsmaterials (33) auf den Inseln (47) der ersten Schicht (63; 65), wobei die zweite Schicht (13), die dritte Schicht (15) und die zweite Teilschicht (49) der ersten Schicht (63; 65) einen bipolaren Transistor (T2) bilden, und **gekennzeichnet durch**, nach Schritt c) einen Epitaxieschritt e) während dem eine vierte Halbleiterschicht (23) zwischen den Inseln (47) der ersten Schicht (63; 65) gebildet wird, und zwischen den Schritten c) und e) einen Schritt zum Ausbilden von elektrisch isolierenden Abstandshaltern (21) um die Inseln (47) herum.

2. Verfahren nach Anspruch 1, das nach Schritt e) einen Schritt des Dotierens eines Bereichs (27) der vierten Schicht (23) des ersten Leitfähigkeitstyps (N) aufweist.

3. Verfahren nach Anspruch 1 oder 2, wobei Gräben (43) in der zweiten (13) und dritten (15) Schicht zwischen den Inseln (47) in Zeilenrichtung ausgebildet werden.

4. Verfahren nach einem der Ansprüche 1 bis 3, wobei während des Schritts d) des Ausbildens von Speicherzellen (M1) eine der Speicherzellen (M1) vis-a-vis jeder Insel (47) ausgebildet wird.

5. Verfahren nach einem der Ansprüche 1 bis 4, wobei die erste Schicht (63; 65) aus Silizium besteht.

6. Verfahren nach Anspruch 5, wobei die erste Schicht (63) aus Polysilizium besteht und durch Abscheidung gebildet wird.

7. Verfahren nach Anspruch 6, wobei die Inseln (47) und Speicherzellen (M1) in einem Speicherbereich (Zm) des Chips ausgebildet sind, wobei der Chip ferner einen Logikbereich (ZI) aufweist, und wobei in Schritt c) ferner in der ersten Schicht (63) gleichzeitig mit den Inseln (47) Gates von MOS-Transistoren einer Logikschaltung ausgebildet werden.

8. Verfahren nach Anspruch 6, wobei die erste Schicht (65) aus einkristallinem Silizium besteht und durch Epitaxie gebildet wird.

9. Elektronischer Chip (45) mit Inseln (47) in einer ersten Schicht (63; 65), die in einem Array aus Zeilen und Spalten sind, wobei die Inseln (47) an der Oberfläche einer zweiten dotierten Halbleiterschicht (13) eines ersten Leitfähigkeitstyps (N) angeordnet sind, die sich ihrerseits auf einer dritten dotierten Halbleiterschicht (15) eines zweiten Leitfähigkeitstyps (P), der dem ersten Leitfähigkeitstyp (N) entgegengesetzt ist, befindet und mit dieser in Kontakt steht, wobei die erste Schicht (63; 65) eine erste dotierte Teilschicht (51) des ersten Leitfähigkeitstyps (N) auf der zweiten Schicht (13) und eine zweite dotierte Teilschicht (49) des zweiten Leitfähigkeitstyps (P) aufweist, wobei die Inseln (47) mit Speicherzellen (M1) auf der Basis eines Phasenwechselmaterials (33) bedeckt sind, wobei die zweite Schicht (13), die dritte Schicht (15) und die zweite Teilschicht (49) der ersten Schicht (63; 65) einen bipolaren Transistor (T2) bilden, **dadurch gekennzeichnet, dass** jede Insel (47) seitlich von elektrisch isolierenden Abstandshaltern (21) umgeben ist, wobei die Vorrichtung ferner eine vierte Halbleiterschicht (23) aufweist, die zwischen den Inseln (47) ausgebildet ist.

10. Elektronischer Chip nach Anspruch 9, wobei die erste Schicht (63) aus Polysilizium besteht.

11. Elektronischer Chip nach Anspruch 9, wobei die erste Schicht (65) aus einkristallinem Silizium besteht.

12. Elektronischer Chip (45) nach Anspruch 9, der durch ein Verfahren nach einem der Ansprüche 1 bis 8 hergestellt ist.

## Claims

1. Electronic chip manufacturing method (45), comprising the following successive steps:
a) forming of a first layer (63; 65) on top of and in contact with a second doped semiconductor layer (13) of a first conductivity type (N), the second layer being on top of and in contact with a third doped semiconductor layer (15) of a second conductivity type (P) opposite to the first conductivity type;
b) doping of the first layer (63; 65) to form, on the second layer, a first doped sub-layer (51) of the first conductivity type (N) and a second doped sub-layer (49) of the second conductivity type (P);
c) forming of islands (47) in the first layer (63; 65) organized in an array of rows and columns at the surface of the second layer (13); and
d) forming of memory cells (M1) based on a phase-change material (33) on the islands (47) of the first layer (63; 65), the second layer (13), the third layer (15), and the second sub-layer (49) of the first layer (63; 65) forming a bipolar transistor (T2)and **characterized in**, after step c), an epitaxy step e) during which a fourth semiconductor layer (23) is formed between the islands (47) of the first layer (63; 65), and, between steps c) and e), a step of forming of electrically-insulating spacers (21) around the islands (47).

2. Method according to claim 1, comprising, after step e), a step of doping of an area (27) of the fourth layer (23) of the first conductivity type (N).

3. Method according to claim 1 or 2, wherein trenches (43) are formed in the second (13) and third (15) layers, between said islands (47), in the row direction.

4. Method according to any of claims 1 to 3, wherein during step d) of forming memory cells (M1), one of said memory cells (M1) is formed in front of each island (47).

5. Method according to any of claims 1 to 4, wherein the first layer (63; 65) is made of silicon.

6. Method according to claim 5, wherein the first layer (63) is made of polysilicon and is formed by deposition.

7. Method according to claim 6, wherein said islands (47) and memory cells (M1) are formed in a memory area (Zm) of the chip, the chip further comprising a logic area (Zl), and wherein, at step c), are further formed, in the first layer (63), at the same time as the islands (47), gates of MOS transistors of a logic circuit.

8. Method according to claim 6, wherein the first layer (65) is made of single-crystal silicon and is formed by epitaxy.

9. Electronic chip (45) comprising islands (47) in a first layer (63; 65) organized in an array of rows and of columns, the islands (47) being arranged at the surface of a second doped semiconductor layer (13) of a first conductivity type (N), itself located on top of and in contact with a third doped semiconductor layer (15) of a second conductivity type (P) opposite to the first conductivity type (N), the first layer (63; 65) comprising a first doped sub-layer (51) of the first conductivity type (N), on the second layer (13) and a second doped sub-layer (49) of the second conductivity type (P), the islands (47) being topped with memory cells (M1) based on a phase-change material (33), the second layer (13), the third layer (15), and the second sub-layer (49) of the first layer (63; 65) forming a bipolar transistor (T2) and **characterized in that** each island (47) is laterally surrounded with electrically-insulating spacers (21), the device further comprising a fourth semiconductor layer (23) is formed between the islands (47).

10. Electronic chip according to claim 9, wherein the first layer (63) is made of polysilicon.

11. Electronic chip according to claim 9, wherein the first layer (65) is made of single-crystal silicon.

12. Electronic chip (45) according to claim 9 formed by a method according to any of claims 1 to 8.
